# EUROPÄISCHE PATENTANMELDUNG

(11) **EP 0 780 662 A2**
(43) Veröffentlichungstag der Anmeldung: **25.06.1997**
(21) Anmeldenummer: 96119244.0
(22) Anmeldetag: 30.11.1996
(51) Int. Cl.: G01D 5/12, H03M 1/22, G01R 1/20

(54) **Vorrichtung zur Eingabe von Einstellwerten**

(30) Priorität: 22.12.1995 DE 19548292
(71) Anmelder: GOSSEN-METRAWATT Gesellschaft mit beschränkter Haftung, D-90471 Nürnberg (DE)
(72) Erfinder: Albert, Markus, 65428 Rüsselsheim (DE); Hänel, Horst, Dr., 90459 Nürnberg (DE); Leugner, Peter, 91301 Forchheim (DE); Brand, Joachim, 90552 Röthenbach (DE); John, Erich, 95502 Himmelkron (DE)
(74) Vertreter: Hafner, Dieter, Dr.rer.nat., Dipl.-Phys.

(57) **Zusammenfassung**

Die Erfindung betrifft eine Vorrichtung zur Eingabe von Einstellwerten in elektronische Geräte, insbesondere Meß-, Regel- und/oder Steuergeräte mit einem manuell betätigbaren Drehknopf (3), der innerhalb eines anschlagbegrenzten Drehwinkelbereichs (4) zur inkrementalen oder dekrementalen Beeinflussung des Einstellwertes verdrehbar ist und einem Anzeigeelement (5), das mit einem an dem Drehknopf (3) angekoppelten elektrischen Verstellelement (6) (Potentiometer, Inkremental- oder Dekrementaldrehgeber) zur elektronischen Anzeige des eingestellten Wertes zusammenwirkt. Durch Verdrehen des Drehknopfes (3) in außenliegende Drehwinkelrandbereiche (8) bewirkt das mechanisch daran angekoppelte elektronische Verstellelement (6) eine laufende inkrementale oder dekrementale Verstellung des Einstellwertes. In einem mittleren Drehwinkelbereich (9) erfolgt eine Feineinstellung des Einstellwertes proportional zur Drehwinkeländerung des Drehknopfes (3). Die außenliegenden Drehwinkelrandbereiche (8) sind in mehrere Drehwinkelunterbereiche unterteilt, wobei in ersten inneren Drehwinkelunterbereichen (11) die Änderungsgeschwindigkeit des Einstellwertes konstant und in zweiten äußeren Drehwinkelunterbereichen (12) die Änderungsgeschwindigkeit des Einstellwertes mit nach außen zunehmenden Drehwinkel steigerbar ist.

## Beschreibung

Die Erfindung betrifft eine Vorrichtung zur Eingabe von Einstellewerten in elektronische Geräte, insbesondere Meß-, Regel- und/oder Steuergeräte, mit den weiteren Merkmalen des Patentanspruchs 1.

Eine bekannte derartige Vorrichtung weist einen manuell betätigbaren Drehknopf auf der aus der Vorderfront des elektronischen Gerätes heraussteht. Der Drehknopf ist innerhalb eines anschlagbegrenzten Drehwinkelbereichs manuell verdrehbar und beeinflußt dabei den Einstellwert inkremental oder dekremental, je nachdem, ob er im oder entgegen dem Uhrzeigersinn verdreht wird. An den Drehknopf ist dazu ein elektrisches Verstellelement in Form eines Potentiometers, eines Drehgebers oder sogenannten Bit-Generators angeschlossen, das elektrisch mit einem Anzeigeelement in Form eines elektronisch angesteuerten Displays zusammenwirkt, auf dem der jeweils eingestellte Wert angezeigt wird. An einer solchen Vorrichtung ist es ferner bereits bekannt, daß beim Verdrehen des Drehknopfes in außenliegende Drehwinkelrandbereiche der Einstellwert durchlaufend nach oben oder nach unten im Sinne einer inkrementalen oder dekrementalen Verstellung verhindert wird, wohingegen bei Verdrehen des Drehknopfes innerhalb eines mittleren Drehwinkelbereichs eine Feineinstellung des Einstellwertes proportional zur Drehwinkeländerung des Drehknopfes erfolgt. Dies bedeutet, daß ausgehend von einem voreingestellten Wert bei einer leichten Verdrehung des Drehknopfes innerhalb des mittleren Drehwinkelbereichs, der Einstellwert beispielsweise um 1, 2 oder mehrere digits erhöht wird, wodurch eine sehr feinfühlige und ergonomische Verstellung des Einstellwertes erzielbar ist. Für Verstellungen über große Bereiche hinaus wird einer der beiden an den mittleren Drehwinkelbereich beidseitig angrenzenden Drehwinkelrandbereiche angesteuert. Der Einstellwert läuft dabei sehr schnell durch, so daß eine feinfühlige Verstellung nicht mehr gegeben ist. Allerdings können in kürzester Zeit Änderungen des Einstellwertes über weite Bereiche hinweg erfolgen.

Der Erfindung liegt die Aufgabe zugrunde, eine Vorrichtung mit den Merkmalen des Oberbegriffs des Patentanspruchs 1 dahingehend weiterzubilden, daß sie auf einfache Weise zum einen eine feinfühligere, zum anderen eine schnellere Eingabe von Einstellwerten in elektronische Geräte ermöglicht, wobei Eingabefehler weitgehend vermieden werden sollen.

Diese Aufgabe wird durch die kennzeichenden Merkmale des Patentanspruchs 1 gelöst. Vorteilhafte Weiterbildungen der Erfindung ergeben sich aus den Unteransprüchen 2 - 13. Die Patentansprüche 14 - 18 beschreiben ein zugehöriges vorteilhaftes Verfahren zur Eingabe von Einstellwerten unter Verwendung der Vorrichtung.

In Weiterbildung des Standes der Technik ist erfindungsgemäß vorgesehen, die Drehwinkelrandbereiche in mehrere unterschiedlich wirkende Drehwinkelunterbereiche zu unterteilen, wobei in einem ersten inneren Drehwinkelunterbereich die Änderungsgeschwindigkeit des Einstellwertes konstant ist, d.h. gleichbleibend nach oben oder nach unten läuft und in einem zweiten äußeren Drehwinkelunterbereich die Änderungsgeschwindigkeit des Einstellwertes mit nach außen zunehmenden Drehwinkel gesteigert werden kann. Wenn somit von einem inneren Drehwinkelunterbereich in einen äußeren Drehwinkelunterbereich hineingefahren wird, kann die Änderungsgeschwindigkeit des Einstellwertes weiter gesteigert werden, so daß in kürzester Zeit sehr schnelle Einstellwertverstellungen über mehrere Größenordnungen durchführbar sind. Dies ist bequem, schnell und weit ergonomischer als beispielsweise die Eingabe von Einstellwerten über Tipptasten.

Als besonders vorteilhaft hat sich die Dimensionierung der einzelnen Drehwinkelbereiche nach den Patentansprüchen 2 - 4 erwiesen. Die automatische Rückführung des Drehknopfes aus den Drehwinkelrandbereichen bis zu den jeweils zugeordneten beidseitigen Übergängen des mittleren Drehwinkelbereiches stellt sicher, daß eine durchlaufende Einstellwerteverstellung nur dann erfolgt, wenn die Bedienungsperson den Drehknopf ganz bewußt in der zugeordneten Stellung festhält.

Durch die Merkmale des Patentanspruchs 6 werden Hystereseerscheinungen im Übergangsbereich zwischen dem mittleren Drehwinkelbereich und den beidseitig angrenzenden Drehwinkelrandbereichen vermieden.

Durch einen Speicher, in welchem der über die Vorrichtung eingegebene Einstellwert laufend zwischenspeicherbar ist, wird die Bedienerfreundlichkeit der Vorrichtung weiter verbessert. Der Speicherwert wird über das Display angezeigt und der Einstellwert erst dann als gültiger Einstellwert in das elektronische Gerät übernommen, wenn der angezeigte Speicherwert eine gewisse Mindestzeit unverändert vorliegt.

Ferner ist vorteilhafterweise vorgesehen, daß der Signalpfad zwischen dem elektrischen Verstellelement und dem Speicher durch eine Steuereinrichtung sperrbar ist und die Steuereinrichtung den Signalpfad nach Übernahme der im Speicher abgelegten Einstellwerte in das elektronische Gerät erst dann wieder freigibt, wenn der Drehknopf über einen vorgebbaren Mindestdrehwinkelbereich verdreht wird, d.h. nicht nur im Mittelbereich um wenige digits, sondern beispielsweise bis in die Randbereiche hinein. Dadurch wird sichergestellt, daß beispielsweise beim Eindrücken des Drehknopfes in eine innere Raststellung keine unbeabsichtigte Verstellung des Einstellwertes erfolgt.

Die Erfindung ist anhand vorteilhafter Ausführungsbeispiele in den Zeichnungsfiguren näher erläutert. Diese zeigen:

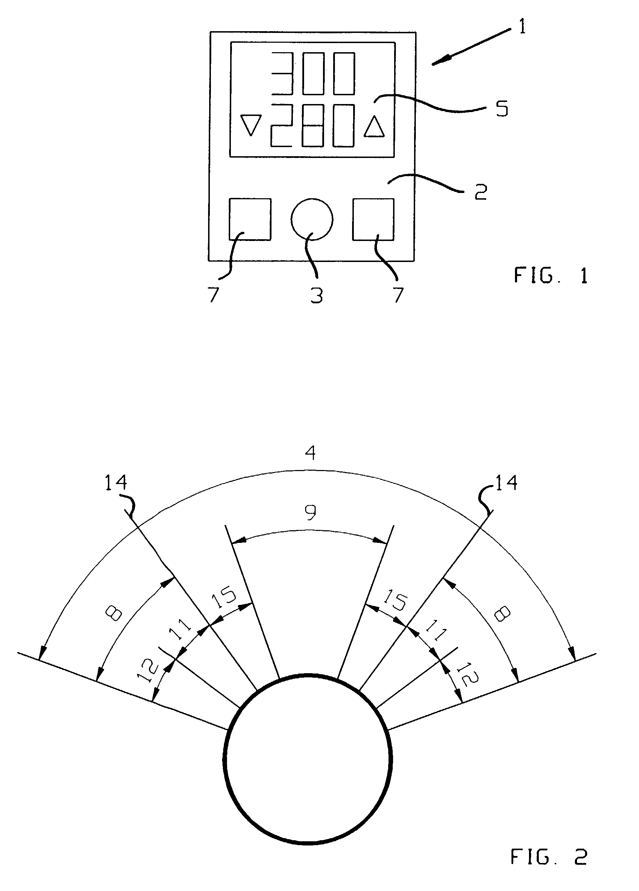

- Fig. 1: eine Frontansicht eines Reglers mit Display und Drehknopf zur Eingabe von Einstellwerten,
- Fig. 2: eine schematische Darstellung des Drehknopfes mit den unterschiedlich wirkenden Drehwinkelbereichen,
- Fig. 3: eine Schnittdarstellung der Vorrichtung, wobei in Fig. 3a der Drehknopf eingedrückt ist und in Fig. 3b der Drehknopf sich in Arbeitsstellung befindet.

In Zeichnungsfig. 1 ist ein Regelgerät 1 dargestellt, das aufgrund der Dimensionierung seiner sichtbaren Frontplatte 2 als 48²-Gerät bezeichnet wird. Aus der Frontplatte 2 steht ein manuell betätigbarer Drehknopf 3 heraus, der innerhalb eines anschlagbegrenzten Drehwinkelbereichs 4 (Fig. 2) zur inkrementalen oder dekrementalen Beeinflussung des Einstellwertes verdrehbar ist. Ferner ist ein Anzeigeelement 5 vorgesehen, das mit einem an den Drehknopf 3 angekoppelten elektrischen Verstellelement 6 in Form eines Potentiometers zur elektronischen Anzeige des eingestellten Wertes zusammenwirkt. Beidseitig des Drehknopfes 3 sind noch Taster 7 vorgesehen, die beispielsweise zur Änderung oder Einstellung der Betriebsart des Regelgerätes 1 dienen können.

Nachfolgend wird auf Zeichnungsfig. 2 Bezug genommen. Wird der Drehknopf 3 aus einem mittleren Drehwinkelbereich 9 in einen der Drehwinkelrandbereiche 8 hineingedreht, so bewirkt das an den Drehknopf 3 angekoppelte elektronische Verstellelement 6 eine laufende inkrementale oder dekrementale Verstellung des Einstellwertes, je nachdem ob vom Drehknopf der rechte bzw. linke Drehwinkelrandbereich 8 angefahren wird. Wird der Drehknopf 3 mit seiner Markierung 10 allerdings im mittleren Drehwinkelbereich 9 bewegt, so bewirkt dies eine Verstellung des Einstellwertes digit für digit, d.h. sehr gefühlvoll.

Die Drehwinkelrandbereiche 8 sind nochmals unterteilt. Im Inneren der ersten Drehwinkelunterbereiche 11 ist die Änderungsgeschwindigkeit des Einstellwertes konstant, in zweiten äußeren Drehwinkelunterbereichen 12 ist die Änderungsgeschwindigkeit des Einstellwertes hingegen nach außen hin, d.h. mit zu den Anschlägen des Drehwinkelbereiches 4 zunehmenden Drehwinkel steigerbar. Die beiden außenliegenden Drehwinkelrandbereiche 8 sind etwa gleich, was ihren Winkel anbelangt und stimmen etwa mit dem Winkel des mittleren Drehwinkelbereiches 9 überein. Der Gesamtdrehwinkel bei dem in Fig. 2 dargestellten Ausführungsbeispiel beträgt etwa 135° und ist somit deutlich kleiner als 180°. Innerhalb der Drehwinkelrandbereiche 8 ist eine Rückstellfeder 13 wirksam, die den Drehknopf 3 aus den Drehwinkelrandbereichen 8 bis zu ihren inneren Rand 14 zurückstellt. Innerhalb des durch die Randlinien 14 eingeschlossenen Winkels ist die Rückstellfeder 13 nicht wirksam. Mit Bezugsziff. 15 sind dritte Drehwinkelunterbereiche bezeichnet, in denen die Änderungsgeschwindigkeit des Einstellwertes Null ist. Die dritten Drehwinkelunterbereiche 15 grenzen beidseitig an den mittleren Drehwinkelbereich 9.

Nachfolgend wird auf Zeichnungsfig. 3 Bezug genommen. Daraus ergibt sich im wesentlichen der mechanische Aufbau der Vorrichtung mit der Rückstellfeder 13. Zunächst ist ersichtlich, daß der Drehknopf 3 in einer innenliegenden Stellung verrastbar ist. Die dazu erforderlichen Rastelemente befinden sich innerhalb der Mechanik des Verstellelementes 6 und wirken auf die Achse 16 des Drehknopfes 3.

Aufdie Achse 16 ist einen ein Seitenarm 17 aufweisendes Kunststoffteil aufgesteckt und kraftschlüssig mit der Achse 16 verbunden. Bei Verdrehen des Drehknopfes 3 lenkt der Seitenarm 17, der zwischen den Enden 18 der Rückstellfeder 13 einliegt, eines der beiden Enden 18 aus, so daß auf ihn eine Rückstellkraft ausgeübt wird, die sich auf den Drehknopf 3 überträgt. Zwischen den beiden Enden 18 und den Seitenkanten des Seitenarmes 17 ist ausreichend Spiel, um den nicht rückgestellten Bereich zwischen den Drehwinkelrandbereichen 8 zu definieren.

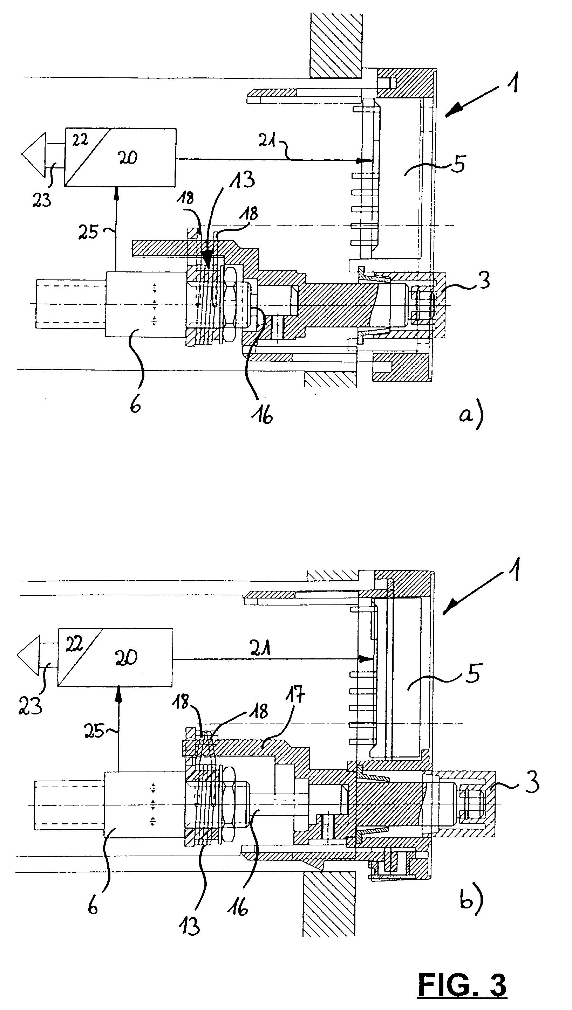

In Fig. 3 ist ferner ein Speicher 20 angedeutet, in dem der über die Vorrichtung eingegebene Einstellwert laufend zwischengespeichert werden kann. Über den Signalpfad 21 der das Anzeigeelement 5 mit dem Speicher 20 verbindet, wird der im Speicher 20 vorliegende Einstellwert an das Anzeigeelement 5 übergeben und dort angezeigt. Erfolgt über einen vorgebbaren Mindestzeitraum keine Änderung des im Speicher 20 vorliegenden Einstellwertes, wird eine Zeitgesteuerte Übergabeeinrichtung 22 wirksam, die den vorliegenden Einstellwert aus dem Speicher 20 als gültigen Einstellwert über eine Signalleitung 23 an das elektronische Regelgerät 1 übergibt.

Ferner ist eine nicht näher dargestellte Sperreinrichtung vorgesehen, die den Signalpfad 25 elektronisch sperrt und erst dann wieder freigibt, wenn eine Verdrehung des Drehknopfes 3 über einen vorgebbaren Mindestdrehwinkelbereich erfolgt ist, wobei der Mindestdrehwinkelbereich unter Bezugnahme auf Fig. 2 die Drehwinkelbereiche 9 und 15 überdecken kann. Andere Drehwinkelbereichsdefinitionen in diesem Zusammenhang sind ebenfalls denkbar.

### BEZUGSZEICHEN

- 1: Regelgerät
- 2: Frontplatte
- 3: Drehknopf
- 4: Drehwinkelbereich
- 5: Anzeigeelement
- 6: Verstellelement
- 7: Tasten
- 8: Drehwinkelrandbereich
- 9: mittlerer Drehwinkelbereich
- 10: Markierung
- 11: innerer Drehwinkelunterbereich
- 12: äußerer Drehwinkelunterbereich
- 13: Rückstellfeder
- 14: Rand
- 15: Drehwinkelunterbereich
- 16: Achse
- 17: Seitenarm
- 18: Ende der Rückstellfeder
- 20: Speicher
- 21: Signalpfad
- 22: Übergabeeinrichtung
- 23: Signalleitung
- 25: Signalpfad

## Patentansprüche

1. Vorrichtung zur Eingabe von Einstellwerten in elektronische Geräte, insbesondere Meß-, Regel- und/oder Steuergeräte mit
- einem manuell betätigbaren Drehknopf (3), der innerhalb eines anschlagbegrenzten Drehwinkelbereichs (4) zur inkrementalen oder dekrementalen Beeinflussung des Einstellwertes verdrehbar ist und
- einem Anzeigeelement (5), das mit einem an dem Drehknopf (3) angekoppelten elektrischen Verstellelement (6) (Potentiometer, Inkremental- oder Dekrementaldrehgeber) zur elektronischen Anzeige des eingestellten Wertes zusammenwirkt, wobei
- bei Verdrehen des Drehknopfes (3) in außenliegende Drehwinkelrandbereiche (8) das mechanisch daran angekoppelte elektronische Verstellelement (6) eine laufende inkrementale oder dekrementale Verstellung des Einstellwertes bewirkt und in einem mittleren Drehwinkelbereich (9) eine Feineinstellung des Einstellwertes proportional zur Drehwinkeländerung des Drehknopfes (3) erfolgt,
**dadurch gekennzeichnet, daß**
- die außenliegenden Drehwinkelrandbereichen (8) in mehrere Drehwinkelunterbereiche unterteilt sind, wobei
- in ersten inneren Drehwinkelunterbereichen (11) die Änderungsgeschwindigkeit des Einstellwertes konstant ist und
- in zweiten äußeren Drehwinkelunterbereichen (12) die Änderungsgeschwindigkeit des Einstellwertes mit nach außen zunehmenden Drehwinkel steigerbar ist.

2. Vorrichtung nach Anspruch 1,
**dadurch gekennzeichnet,**
daß die Winkel der beiden außenliegenden Drehwinkelrandbereiche (8) etwa gleich sind.

3. Vorrichtung nach Anspruch 1 oder 2,
**dadurch gekennzeichnet,**
daß der Winkel des mittleren Drehwinkelbereichs (9) etwa dem der Drehwinkelrandbereiche (8) entspricht.

4. Vorrichtung nach einem der Ansprüche 1 - 3,
**dadurch gekennzeichnet,**
daß der Gesamtdrehwinkel <360°, insbesondere im Bereich von 120 - 140° ist.

5. Vorrichtung nach einem der vorhergehenden Ansprüche,
**dadurch gekennzeichnet,**
daß mindestens eine Rückstellfeder (13) vorgesehen ist, durch die der Drehknopf (3) selbsttätig aus den Drehwinkelrandbereichen (8) bis zu den zugeordneten Übergängen des mittleren Drehwinkelbereichs (9) rückfühbar ist.

6. Vorrichtung nach einem der vorhergehenden Ansprüche,
**dadurch gekennzeichnet,**
daß in dritten, an den mittleren Drehwinkelbereichen (9) beidseitig angrenzenden Drehwinkelunterbereichen (15) die Änderungsgeschwindigkeit des Einstellwertes Null ist.

7. Vorrichtung nach einem der vorhergehenden Ansprüche,
**dadurch gekennzeichnet,**
daß sie einen Speicher (20) aufweist, in welchem der über die Vorrichtung eingegebene Einstellwert laufend zwischenspeicherbar ist.

8. Vorrichtung nach Anspruch 7,
**dadurch gekennzeichnet,**
daß der abgespeicherte Einstellwert durch eine zeitgesteuerte Übergabeeinrichtung (22) bei unverändertem Vorliegen des Einstellwertes über einen vorgebbaren Mindestzeitraum als gültiger Einstellwert in das elektronische Regelgerät (1) übernehmbar ist.

9. Vorrichtung nach einem der vorhergehenden Ansprüche,
**dadurch gekennzeichnet,**
daß der Signalpfad (25) zwischen dem elektrischen Verstellelement (6) und dem Speicher (20) durch eine Steuereinrichtung sperrbar ist und die Steuereinrichtung den Signalpfad (25) nach Übernahme der im Speicher (20) abgelegten Einstellwerte in das elektronische Regelgerät (1) erst dann freigibt, wenn eine Verdrehung des Drehknopfes (3) über einen vorgebbaren Mindestdrehwinkelbereich erfolgt.

10. Vorrichtung nach einem der vorhergehenden Ansprüche,
**dadurch gekennzeichnet,**
daß der Mindestdrehwinkelbereich der mittlere Drehwinkelbereich (9) ist.

11. Vorrichtung nach einem der vorhergehenden Ansprüche,
**dadurch gekennzeichnet,**
daß der Mindestdrehwinkelbereich in die dritten Drehwinkelunterbereiche (15) hineinreicht.

12. Vorrichtung nach einem der vorhergehenden Ansprüche,
**dadurch gekennzeichnet,**
daß der Drehknopf (3) gegen Federkraft von einer äußeren Arbeitsstellung in eine innere, versenkte Ruhestellung eindrückbar und verrastbar ist.

13. Vorrichtung nach einem der vorhergehenden Ansprüche,
**dadurch gekennzeichnet,**
daß die Drehwinkelunterbereiche (11, 12, 15) bezogen auf die Mitte des mittleren Drehwinkelbereiches (9) symmetrisch angeordnet sind.

14. Verfahren zur Eingabe von Einstellwerten in elektronische Geräte, insbesondere Meß-, Regel- und/oder Steuergeräte, bei welchem über einen manuell betätigbaren Drehknopf der innerhalb eines anschlagbegrenzten Drehwinkelbereichs verdrehbar ist, Einstellwerte inkremental oder dekremental beeinflußt werden können und über ein Anzeigeelement angezeigt werden, das mit einem an den Drehknopf angeschlossenen elektrischen Verstellelement zusammenwirkt, wobei das Verdrehen des Drehknopfes in einem mittleren Drehwinkelbereich eine proportional zur Drehwinkeländerung des Drehknopfes verlaufende Feineinstellung des Einstellwertes bewirkt und eine Verdrehung des Drehknopfes in außenliegende Drehwinkelrandbereiche dazu führt, daß der Einstellwert laufend inkremental oder dekremental verstellt wird, wobei in ersten äußeren Drehwinkelunterbereichen die Änderungsgeschwindigkeit des Einstellwertes konstant ist und in zweiten äußeren Drehwinkelunterbereichen die Änderungsgeschwindigkeit des Einstellwertes mit nach außen zunehmenden Drehwinkel bedarfsweise gesteigert werden kann.

15. Verfahren nach Anspruch 14,
**dadurch gekennzeichnet,**
daß zwischen dem mittleren Drehwinkelbereich und den ersten äußeren Drehwinkelunterbereichen dritte Drehwinkelunterbereiche liegen, in denen die Änderungsgeschwindigkeit des Einstellwertes Null ist.

16. Verfahren nach einem der Ansprüche 14 oder 15,
**dadurch gekennzeichnet,**
daß die auf dem Anzeigeelement erscheinenden Einstellwerte zunächst in einem Zwischenspeicher abgelegt und erst dann als gültiger Einstellwert in das Gerät übernommen werden, wenn über einen Mindestzeitraum keine Veränderung des auf dem Anzeigeelement erscheinenden Einstellwertes erfolgt ist.

17. Verfahren nach einem der Ansprüche 14 - 16,
**dadurch gekennzeichnet,**
daß nach Übernahme des Einstellwertes aus dem Zwischenspeicher in das elektronische Gerät der Drehknopf solange elektronisch deaktiviert ist, bis er zur Reaktivierung der Vorrichtung über einen Mindestdrehwinkelbereich verdreht wird.

18. Verfahren nach Anspruch 16,
**dadurch gekennzeichnet,**
daß der Drehknopf zur Aktivierung der Vorrichtung nach Übernahme des Einstellwertes vom Zwischenspeicher in das Gerät bis in die außenliegenden Drehwinkelrandbereiche hineinverdreht werden muß.
